# EUROPEAN PATENT SPECIFICATION

(11) **EP 1 113 277 B1**
(45) Date of publication and mention of the grant of the patent: **15.11.2006**
(21) Application number: 99204602.9
(22) Date of filing: 29.12.1999
(51) Int. Cl.: G01R 15/20, G01R 1/20

(54) **A bushing element for medium and high voltage applications**
Durchführungselement für Mittel- und Hochspannungsanwendungen
Elément de traversée pour applications de tension moyenne et haute

(43) Date of publication of application: 04.07.2001
(73) Proprietor: ABB Technology AG, 8050 Zürich (CH)
(72) Inventor: Guida, Cesare, 20122 Milano (IT); Colombo, Franco, 21046 Malnate-Varese (IT)
(74) Representative: Giavarini, Francesco

(56) References cited:
- EP-A- 0 917 157
- DE-A- 4 435 864
- US-A- 5 250 894
- SCOVILLE J T ET AL: "A LOW-COST MULTIPLE HALL PROBE CURRENT TRANSDUCER" REVIEW OF SCIENTIFIC INSTRUMENTS,US,AMERICAN INSTITUTE OF PHYSICS. NEW YORK, vol. 62, no. 3, 1 March 1991 (1991-03-01), pages 755-760, XP000224321 ISSN: 0034-6748
- PATENT ABSTRACTS OF JAPAN vol. 016, no. 059 (E-1166), 14 February 1992 (1992-02-14) & JP 03 257909 A (MITSUBISHI ELECTRIC CORP), 18 November 1991 (1991-11-18)
- PATENT ABSTRACTS OF JAPAN vol. 016, no. 046 (P-1307), 5 February 1992 (1992-02-05) & JP 03 249564 A (MITSUBISHI ELECTRIC CORP), 7 November 1991 (1991-11-07)

## Description

The present invention relates to a bushing element for medium and high voltage applications (i.e. for a voltage range higher than 1 KV).

More particularly the present invention relates a bushing element, which allows measuring, in an improved manner, a current flowing in a conductor, which is positioned internally to the body of the bushing element.

In the field of the medium and high voltage applications, many techniques are used, in the state of the art, for performing the measurement of a current in a conductor. Traditionally, thanks to their high level of precision and reliability, instrumentation transformers are used. Often, particularly in applications such as medium and high voltage switchgears (circuit breaker, disconnectors and the like), said instrumentation transformers have been integrated in a bushing element, preferably provided with an insulating body, so as to save a remarkable quantity of room.

In practice, inside the insulating body of the bushing element, it is provided a first conductor on which flows the current to be measured.

This conductor represents the primary winding of the instrumentation transformer while secondary windings, wounded around a magnetic core, provide a signal indicative of the current flowing on the first conductor.

The main drawback of these devices is given, in a first instance, by the considerable weight of the instrumentation transformer, mainly due to the presence of a magnetic core. Moreover, other drawbacks arise from the intrinsic limitations of magnetic core transformers such as, for example, the limited range of measurable current due to the magnetic core saturation or the impossibility of measuring a DC current.

In order to solve these problems, a different kind of bushing elements has been introduced in the state of the art. In practice, in the insulating body of said bushing elements an iron-less current transformer (such as for example a Rogowsky coil) is integrated. In this manner, all the drawbacks deriving from the presence of a magnetic core can be avoided.

Unfortunately, even if this kind bushing elements has represented an important improvement in the state of the art, some drawbacks still remain.

First, due to the fact that the transformer integrated in the insulating body of the bushing element is without a magnetic core, a high number of secondary windings are needed in order to obtain a measurement signal having an acceptable magnitude. Moreover, the precision of the current measurements is strictly dependent, in this kind of iron-less transformers, on the geometry of the secondary winding which must be realised with a high level of accuracy. These facts imply that high production costs are required for the realisation of the iron-less transformer and consequently for the realisation of the bushing element wherein said iron-less transformer is integrated.

Moreover the need of an high number of secondary windings does not allow a remarkable reduction of the size of the bushing element. For this reason, it is difficult to shape the bushing element in various manners, in order to adapt it to various kinds of applications.

EP-A2-0917157 discloses a bushing insulator comprising a current measuring element and a voltage measuring element in a concentric arrangement around a measured conductor.

In Scoville's paper, titled "A low-cost multiple Hall probe current transducer", Review of Scientific Instruments, March 1991, New York, several Hall sensors are embedded in a insulator surrounding a current carrying conductor.

DE-A1-4435864 discloses a socket with an insulator comprising sensors that are casted or moulded.

Main aim of the present invention is to provide a bushing element which allows performing a measurement of a current flowing in a conductor, positioned internally to the body of the bushing element, with a remarkable reduction of the size and the production costs of the bushing element.

Within this aim, another object of the present invention is to provide a bushing element, which is easy to fabricate and install, according to the needs.

Another object of the present invention is to provide a bushing element which allows performing a measurement of a current flowing in a conductor, positioned internally to the body of the bushing element, with an high level accuracy.

Another object of the present invention is to provide a bushing element which allows performing a measurement of a current flowing in a conductor, positioned internally to the body of the bushing element, with an extended measuring range, including both AC and DC currents.

Another object of the present invention is to provide a bushing element which allows performing a measurement of a current flowing in a conductor, positioned internally to the body of the bushing element, with the possibility of integrating the current measurement with voltage measurements.

Not the least object of the present invention is to provide a bushing element which allows performing a measurement of a current flowing in a conductor, positioned internally to the body of the bushing element, with the possibility of being easily used and integrated in the most common medium and high voltage applications.

Thus, the present invention provides a bushing element, for medium and high voltage applications, which comprises an insulating body, arranged for including a conductor positioned internally, characterised by the features of claim 1.

The bushing element, according to the present invention, allows fully achieving the intended aims.

The presence of a plurality of sensors that make a plurality of point measurements allow reducing the size of said sensors to negligible dimensions. Consequently, they can easily be integrated in the insulating body of the bushing element, according to the present invention, with a remarkable reduction of the size and the production costs of the bushing element.

Moreover the bushing element, according to the invention, can be fabricated and shaped according to the needs. In this way, it can be easily used and integrated in the most common medium and high voltage applications.

Further characteristics and advantages of the invention shall emerge more clearly from the description of preferred but not exclusive embodiments of the bushing element according to the present invention, that are illustrated purely by way of example and without limitation in the attached drawings, wherein:
figure 1 is a diagram, which illustrates a schematic view of the bushing element, according to the present invention, in a preferred embodiment;
figure 2 is a diagram, which illustrates a schematic view of the bushing element, according to the present invention, in a further embodiment.

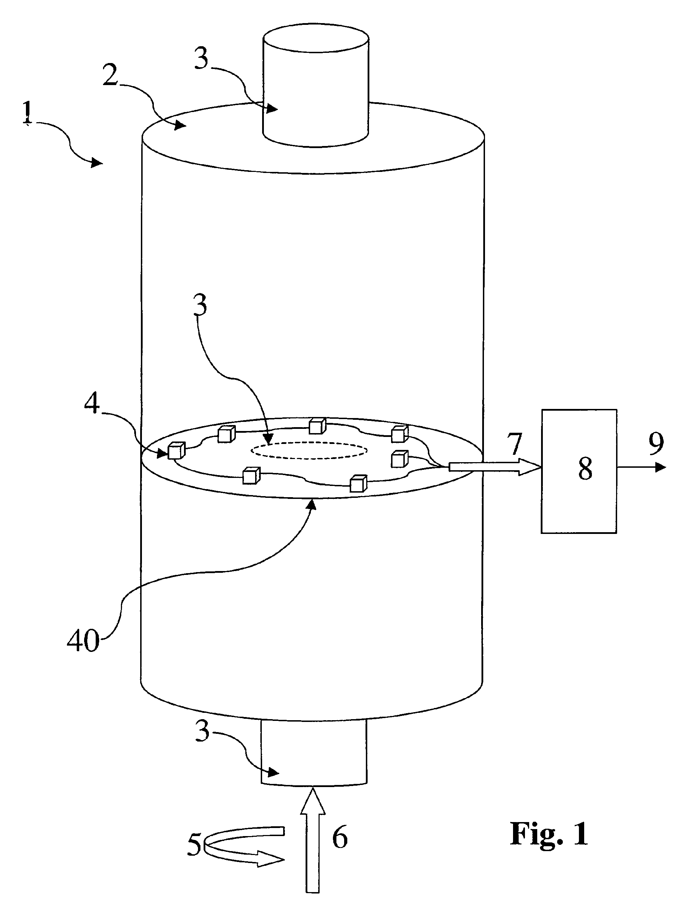

Referring to figure 1 a schematic view of the bushing element, according to the present invention, is shown. In particular a transversal section of the bushing element, according to the invention, is shown.

The bushing element, indicated by reference 1, comprises an insulating body 2, which is arranged so as to include a conductor 3. The conductor 3 is positioned internally to the insulating body 2. The insulating body 2 can advantageously be made of polymeric material such as for example polymeric resins or solid insulating foams.

The insulating body 2 comprises a plurality of sensors 4 that perform a plurality of point measurements of the magnetic field (arrow 5) generated by a current (arrow 6) flowing in the conductor 3.

The plurality of sensors 4 generates, based on said plurality of point measurements, first measuring signals 7, that are indicative of the value of current 6 flowing in the conductor 3.

The plurality of sensor 4 is preferably arranged in a planar array structure 40, which is buried in the insulating body 2.

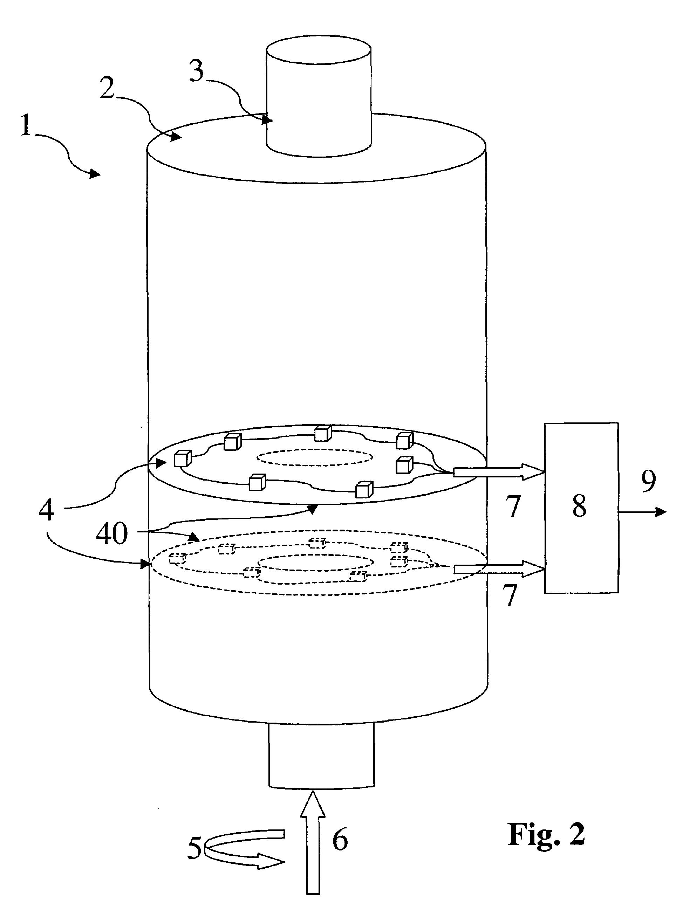

Said structure 40 can preferably have a circular geometry, positioned around the conductor 2, as illustrated in figure 2. This solution is quite advantageous due to reasons of symmetry. Also a polygonal geometry can advantageously considered.

Alternatively, as illustrated schematically in figure 2, the plurality of sensors can be arranged in a three-dimensional array structure, which is buried in the insulating body 2. Said three-dimensional array structure can comprise for example a sequence of planar array structures 40 along the direction in which the current 6 flows.

Accordingly to what described above, said three-dimensional array can have a cylindrical geometry, positioned around the conductor 3, or alternatively a polyedron geometry. This kind of array structure can have multiple advantages. First, an improvement of the accuracy of the measurements can be achieved, for example implementing differential calculations. Moreover, am improvement of the reliability is possible, being possible to have a redundant system, which can overcome possible situations of failure of one of the array structures.

As mentioned the aim of the plurality of sensors 4 is to perform a plurality of point measurements of the magnetic field 5. For this aim, solid state magnetic field sensors can easily used. In particular, hall effect sensors and/or magneto-resistive sensors and/or giant magneto-resistive sensors can be preferably considered.

The fact that point measurements of the magnetic field are executed by the plurality of sensors 4, implies that their size is definitively negligible. For this reason, they can be moulded or casted in the insulating body 2. This fact is particularly advantageous because it allows a complete freedom in the activity of sizing and shaping the bushing element 1. In this way, the bushing element 1 can be easily arranged according to the needs.

According to the invention, the insulating body 2 comprises electronic means 8 for processing the first measuring signals 7. Preferably, the electronic means 8 generates a compensated second measuring signal 9, which is indicative of the value of current 6 flowing in the conductor 3. In practice the signal 9 is generated, compensating possible inaccuracies that can arise due to lack of symmetry of the placement of the sensors 4. Simple electronic circuits, well known to the skilled artisan, can be used for processing the signal 7. According to the invention, one or more of said electronic circuits, are moulded or casted in the insulating body 2.

It should be noticed that the presence of electronics, connected to the sensors 4 does not cause problems in terms of insulation, even if the bushing element 1 is used at medium or high voltages. In fact, the insulation of the sensors 4 is intrinsically provided by the insulating body 2 where said plurality of sensors 4 is buried.

Moreover, the influence of external fields can be reduced to negligible values even if point measurements of the magnetic field 5 are performed.

This can be obtained in various ways that are known in the state of the art.

For a example a F. E. (Finite Element) modelling of the exact value of the magnetic field in the spatial position where each sensor is placed can be easily performed using one of the computerised tools that are available on the market. In this way, the electronic means 8 can comprise one or more custom circuits, appropriately arranged.

Further, also digital processing techniques, known in the state of the art, can be used. For example, the electronic means 8 can comprise a digital signal processor (DSP) and/or a microcontroller, implementing interference rejection algorithms based on DFT (Digital Fourier Transform) analysis. In this case, first measuring signals 7 can be externally brought to a control unit, comprising the DSP and/or the microcontroller, which first executes an A/D conversion and subsequently processes the sampled measurement values.

In this way a relatively high level of accuracy of the performed measurements can be reached.

In a preferred embodiment the insulating body 2 comprises at least a voltage sensor (not illustrated), which generates a signal indicative of the voltage of the conductor 3. This solution is particularly advantageous due to the fact that the bushing elements can integrally perform measurement of the electric power flowing in the conductor 3.

Said voltage sensor can be one of those well known in the state of the art. In particular capacitor sensors can be advantageously used.

Accordingly, other kind of sensors (for example a temperature sensor) can be integrated in the insulating body 2, so as to provide further useful information related to the operating state of the bushing element 1.

The bushing element according to the present invention has proven to be suitable for the use in the most common medium and high voltage applications. For example, it can be advantageously used as insulating body of one or more electric poles of a medium voltage switchgear, such as for example a circuit breaker, a disconnector, a contactor or the like.

This can be obtained thanks to the fact that the bushing element 10 can be successfully used as a common bushing insulator allowing, in the same time, performing at least a current measurement with a high level of accuracy.

Thanks to its flexibility in the use, the bushing element 10, according the present invention, can be used as a current sensor in medium/high voltage power distribution lines. In this case, one or more the bus-bars used for supplying electric power to a load, can represent the conductor 3, which is positioned internally the insulating body 2 of the bushing element 1.

Accordingly, the bushing element according to the present invention can be easily used in medium voltage switchboards.

The bushing element according to the present invention is susceptible of numerous modifications and variations, all of which are within the scope of the claims.

## Claims

1. A bushing element (1), for medium and high voltage applications, comprising an insulating body (2), arranged for including a conductor (3) positioned internally, said insulating body (2) comprising a plurality of sensors (4) which perform a plurality of point measurements of the magnetic field (5) generated by a current flowing in said conductor (3), said plurality of sensors (4) generating, based on said plurality of point measurements, first measuring signals (7), that are indicative of the value of current flowing in said conductor (3), **characterised by** the fact that said sensors (4) are moulded or casted in said insulating body (2) which comprises electronic means (8) for processing said first measuring signals, said electronic means (8) comprising one or more electronic circuits, that are moulded or casted in the insulating body (2) of said bushing element (1).

2. A bushing element (1), according to claim 1, **characterized by** the fact that said plurality of sensors (4) is arranged in a planar array structure (40), which is buried in said insulating body (2).

3. A bushing element (1), according to claim 1, **characterized by** the fact that said plurality of sensors (4) is arranged in a three-dimensional array structure, which is buried in said insulating body (2).

4. A bushing element (1), according to claim 2, **characterized by** the fact that said planar array structure (40) has an approximately circular geometry, positioned around the conductor (3) included in said insulating body (2).

5. A bushing element (1), according to claim 2, **characterized by** the fact said planar array structure (40) has an approximately polygonal geometry, positioned around the conductor (3) included in said insulating body (2).

6. A bushing element (1), according to claim 3, **characterized by** the fact that said three-dimensional array structure has an approximately cylindrical geometry, positioned around the conductor (3) included in said insulating body (2).

7. A bushing element (1), according to claim 3, **characterized by** the fact that said three-dimensional array structure has an approximately polyedronal geometry, positioned around the conductor (3) included in said insulating body (2).

8. A bushing element (1), according to one or more of the claims from 1 to 7, **characterised by** the fact that said electronic means (8) generate a compensated second measuring signal, which is indicative of the value of current flowing in the conductor (3), comprised in the insulating body (2) of said bushing element (1).

9. A bushing element (1), according to one or more of the claims from 1 to 8, **characterised by** the fact that said electronic means (8) comprises a control unit connected to said plurality of sensors (4), said control unit receiving and processing said plurality of first measurement signals (7) through a digital signal processor and/or a microcontroller.

10. A bushing element (1), according to one or more of the claims from 1 to 9, **characterised by** the fact that said insulating body (2) comprises at least a voltage sensor.

11. A bushing element (1), according to claim 10, **characterised by** the fact that said voltage sensor generates a signal, which is indicative of the voltage of the conductor (3) which is positioned internally the insulating body (2) of said bushing element (1).

12. A bushing element (1), according to one or more of the claims from 1 to 11, **characterised by** the fact that said insulating body (2) comprises one or more sensors (4) for generating signals providing additional information related to the operating state of said bushing element (1).

13. A bushing element (1), according to one or more of the claims from 1 to 12, **characterised by** the fact that said insulating body (2) is made of polymeric materials.

14. A bushing element (1), according to claim 13, **characterised by** the fact that said insulating body (2) is made of insulating polymeric resins.

15. A bushing element (1), according to claim 13, **characterised by** the fact that said insulating body (2) is made of insulating solid foams.

16. A bushing element (1), according to one or more of the claims from 1 to 15, **characterised by** the fact that said plurality of sensors (4) comprises solid state magnetic filed sensors.

17. A bushing element (1), according to claim 16, **characterised by** the fact that said plurality of sensors (4) comprises hall effect sensors and/or magneto-resistive sensors and/or giant magneto-resistive sensors.

18. A medium and/or high voltage switchgear **characterised by** the fact of comprising a bushing element (1) according to one or more of the claims from 1 to 17.

19. A medium and/or high voltage power distribution line **characterised by** the fact of comprising a bushing element (1) according to one or more of the claims from 1 to 17.

20. A medium voltage switchboard **characterised by** the fact of comprising a bushing element (1) according to one or more of the claims from 1 to 17.

## Patentansprüche

1. Buchsenelement (1) für Mittel- und Hochspannungsanwendungen, welches folgendes aufweist: einen isolierenden Körper (2), der dafür ausgelegt ist, in seinem Inneren einen Leiter (3) aufzunehmen, wobei der isolierende Körper (2) eine Vielzahl von Sensoren (4) aufweist, welche eine Vielzahl von Punktmessungen des Magnetfelds (5), das von einem in dem Leiter (3) fließenden Strom erzeugt wird, durchführen, wobei die Vielzahl von Sensoren (4) aufgrund der Vielzahl von Punktmessungen erste Messsignale (7) erzeugen, die den Wert des im ersten Leiter (3) fließenden Stroms anzeigen, **dadurch gekennzeichnet, dass** die Sensoren (4) in den isolierenden Körper (2), der elektronische Mittel (8) zur Verarbeitung der ersten Messsignale aufweist, eingeformt oder eingegossen sind, wobei die elektronischen Mittel (8) eine oder mehrere elektronische Schaltungen einschließen, die in den isolierenden Körper (2) des Buchsenelements (1) eingeformt oder eingegossen sind.

2. Buchsenelement (1) nach Anspruch 1, **dadurch gekennzeichnet, dass** die Vielzahl von Sensoren (4) in einer planen Gruppenstruktur (40), die in dem isolierenden Körper (2) vergraben ist, angeordnet sind.

3. Buchsenelement (1) nach Anspruch 1, **dadurch gekennzeichnet, dass** die Vielzahl von Sensoren (4) in einer dreidimensionalen Gruppenstruktur, die in dem isolierenden Körper (2) vergraben ist, angeordnet sind.

4. Buchsenelement (1) nach Anspruch 2, **dadurch gekennzeichnet, dass** die plane Gruppenstruktur (40) eine annähernd kreisförmige Geometrie aufweist und um den Leiter (3), der in dem isolierenden Körper (2) enthalten ist, angeordnet ist.

5. Buchsenelement (1) nach Anspruch 2, **dadurch gekennzeichnet, dass** die plane Gruppenstruktur (40) eine annähernd polygonale Geometrie aufweist und um den Leiter (3), der in dem isolierenden Körper (2) enthalten ist, angeordnet ist.

6. Buchsenelement (1) nach Anspruch 3, **dadurch gekennzeichnet, dass** die dreidimensionale Gruppenstruktur eine annähernd zylindrische Geometrie aufweist und um den Leiter (3), der in dem isolierenden Körper enthalten ist, angeordnet ist.

7. Buchsenelement (1) nach Anspruch 3, **dadurch gekennzeichnet, dass** die dreidimensionale Gruppenstruktur eine annähernd polyedrische Geometrie aufweist und um den Leiter (3), der in dem isolierenden Körper enthalten ist, angeordnet ist.

8. Buchsenelement (1) nach einem der Ansprüche 1 bis 7, **dadurch gekennzeichnet, dass** die elektronischen Mittel (8) ein kompensiertes zweites Messsignal erzeugen, das den Wert des Stroms anzeigt, der in dem im isolierenden Körper (2) des Buchsenelements enthaltenen Leiter (3) fließt.

9. Buchsenelement (1) nach einem der Ansprüche 1 bis 8, **dadurch gekennzeichnet, dass** das elektronische Mittel (8) eine Steuereinheit aufweist, die mit der Vielzahl von Sensoren (4) verbunden ist, wobei die Steuereinheit die Vielzahl von ersten Messsignalen (7) über einen digitalen Signalprozessor und/oder einen Mikrocontroller empfängt und verarbeitet.

10. Buchsenelement (1) nach einem der Ansprüche 1 bis 9, **dadurch gekennzeichnet, dass** der isolierende Körper (2) mindestens einen Spannungssensor aufweist.

11. Buchsenelement (1) nach Anspruch 10, **dadurch gekennzeichnet, dass** der Spannungssensor ein Signal erzeugt, das die Spannung des Leiters (3) anzeigt, der im isolierenden Körper (2) des Buchsenelements (1) angeordnet ist.

12. Buchsenelement (1) nach einem der Ansprüche 1 bis 11, **dadurch gekennzeichnet, dass** der isolierende Körper (2) einen oder mehrere Sensoren (4) zur Erzeugung von Signalen, welche zusätzliche Informationen mit Bezug auf den Betriebszustand des Buchsenelements (1) liefern, einschließt.

13. Buchsenelement (1) nach einem der Ansprüche 1 bis 12, **dadurch gekennzeichnet, dass** der isolierende Körper (2) aus polymeren Materialien gefertigt ist.

14. Buchsenelement (1) nach Anspruch 13, **dadurch gekennzeichnet, dass** der isolierende Körper (2) aus isolierenden Polymerharzen gefertigt ist.

15. Buchsenelement (1) nach Anspruch 13, **dadurch gekennzeichnet, dass** der isolierende Körper (2) aus isolierenden festen Schäumen gefertigt ist.

16. Buchsenelement (1) nach einem der Ansprüche 1 bis 15, **dadurch gekennzeichnet, dass** die Vielzahl von Sensoren (4) Festzustands-Magnetfeldsensoren einschließen.

17. Buchsenelement (1) nach Anspruch 16, **dadurch gekennzeichnet, dass** die Vielzahl von Sensoren (4) Halleffektsensoren und/oder magneto-resistive Sensoren und/oder magneto-resistive Giant-Sensoren einschließen.

18. Mittel- und/oder Hochspannungs-Schaltanlage, **dadurch gekennzeichnet, dass** sie ein Buchsenelement (1) nach einem der Ansprüche 1 bis 17 einschließt.

19. Mittel- und/oder Hochspannungs-Leistungsverteilungsleitung, **dadurch gekennzeichnet, dass** sie ein Buchsenelement (1) nach einem der Ansprüche 1 bis 17 einschließt.

20. Mittelspannungs-Schaltanlage, **dadurch gekennzeichnet, dass** sie ein Buchsenelement (1) nach einem der Ansprüche 1 bis 17 einschließt.

## Revendications

1. Elément de traversée sous forme de manchon (1), pour des applications moyenne et haute tensions, comprenant un corps isolant (2), agencé pour comprendre un conducteur (3) positionné intérieurement, ledit corps isolant (2) comprenant une pluralité de capteurs (4) qui effectuent une pluralité de mesures ponctuelles du champ magnétique (5) généré par un courant circulant dans ledit conducteur (3), ladite pluralité de capteurs (4) générant, sur la base de ladite pluralité de mesures ponctuelles, des premiers signaux de mesure (7), qui sont indicatifs de la valeur du courant circulant dans ledit conducteur (3), **caractérisé par le fait que** lesdits capteurs (4) sont moulés ou coulés dans ledit corps isolant (2) qui comprend des moyens électroniques (8) pour traiter lesdits premiers signaux de mesure, lesdits moyens électroniques (8) comprenant un ou plusieurs circuits électroniques, qui sont moulés ou coulés dans le corps isolant (2) dudit élément de traversée (1).

2. Elément de traversée (1), selon la revendication 1, **caractérisé par le fait que** ladite pluralité de capteurs (4) sont agencés en une structure de réseau plane (40), qui est enfouie dans ledit corps isolant (2).

3. Elément de traversée (1), selon la revendication 1, **caractérisé par le fait que** ladite pluralité de capteurs (4) sont agencés en une structure de réseau tridimensionnelle, qui est enfouie dans ledit corps isolant (2).

4. Elément de traversée (1), selon la revendication 2, **caractérisé par le fait que** ladite structure de réseau plane (40) a une géométrie à peu près circulaire, positionnée autour du conducteur (3) compris dans ledit corps isolant (2).

5. Elément de traversée (1), selon la revendication 2, **caractérisé par le fait que** ladite structure de réseau plane (40) a une géométrie à peu près polygonale, positionnée autour du conducteur (3) compris dans ledit corps isolant (2).

6. Elément de traversée (1), selon la revendication 3, **caractérisé par le fait que** ladite structure de réseau tridimensionnelle a une géométrie à peu près cylindrique, positionnée autour du conducteur (3) compris dans ledit corps isolant (2).

7. Elément de traversée (1), selon la revendication 3, **caractérisé par le fait que** ladite structure de réseau tridimensionnelle a une géométrie à peu près polyédrique, positionnée autour du conducteur (3) compris dans ledit corps isolant (2).

8. Elément de traversée (1), selon une ou plusieurs des revendications 1 à 7, **caractérisé par le fait que** lesdits moyens électroniques (8) génèrent un deuxième signal de mesure compensé, qui est indicatif de la valeur du courant circulant dans le conducteur (3), compris dans le corps isolant (2) dudit élément de traversée (1).

9. Elément de traversée (1), selon une ou plusieurs des revendications 1 à 8, **caractérisé par le fait que** lesdits moyens électroniques (8) comprennent une unité de commande connectée à ladite pluralité de capteurs (4), ladite unité de commande recevant et traitant ladite pluralité de premiers signaux de mesure (7) par l'intermédiaire d'un processeur de signal numérique et/ou d'un microcontrôleur.

10. Elément de traversée (1), selon une ou plusieurs des revendications 1 à 9, **caractérisé par le fait que** ledit corps isolant (2) comprend au moins un capteur de tension.

11. Elément de traversée (1), selon la revendication 10, **caractérisé par le fait que** ledit capteur de tension génère un signal, qui est indicatif de la tension du conducteur (3) qui est positionné à l'intérieur du corps isolant (2) dudit élément de traversée (1).

12. Elément de traversée (1), selon une ou plusieurs des revendications 1 à 11, **caractérisé par le fait que** ledit corps isolant (2) comprend un ou plusieurs capteurs (4) pour générer des signaux fournissant des informations supplémentaires concernant l'état de fonctionnement dudit élément de traversée (1).

13. Elément de traversée (1), selon une ou plusieurs des revendications 1 à 12, **caractérisé par le fait que** ledit corps isolant (2) est réalisé en des matériaux polymères.

14. Elément de traversée (1), selon la revendication 13, **caractérisé par le fait que** ledit corps isolant (2) est réalisé en des résines polymères isolantes.

15. Elément de traversée (1), selon la revendication 13, **caractérisé par le fait que** ledit corps isolant (2) est réalisé en des mousses dures isolantes.

16. Elément de traversée (1), selon une ou plusieurs des revendications 1 à 15, **caractérisé par le fait que** ladite pluralité de capteurs (4) comprend des capteurs de champ magnétique à semi-conducteurs.

17. Elément de traversée (1), selon la revendication 16, **caractérisé par le fait que** ladite pluralité de capteurs (4) comprend des capteurs à effet Hall et/ou des capteurs magnétorésistifs et/ou des capteurs magnétorésistifs géants.

18. Dispositif de commutation moyenne et/ou haute tensions **caractérisé par le fait qu'**il comprend un élément de traversée (1) selon une ou plusieurs des revendications 1 à 17.

19. Ligne de distribution d'énergie moyenne et/ou haute tensions **caractérisée par le fait qu'**elle comprend un élément de traversée (1) selon une ou plusieurs des revendications 1 à 17.

20. Tableau moyenne tension **caractérisé par le fait qu'**il comprend un élément de traversée (1) selon une ou plusieurs des revendications 1 à 17.
